(19) Europäisches Patentamt
European Patent Office
Office européen des brevets

(11) **EP 2 785 000 B1**

(12) **EUROPEAN PATENT SPECIFICATION**

(45) Date of publication and mention
of the grant of the patent:
**06.11.2019 Bulletin 2019/45**

(51) Int Cl.:
***H04L 27/36*** *(2006.01)*      ***H04L 27/20*** *(2006.01)*
***H03C 1/62*** *(2006.01)*

(21) Application number: **13305357.9**

(22) Date of filing: **25.03.2013**

(54) **Method and Apparatus for Gernerating Quadrature Modulated Signals**

Verfahren und Vorrichtung zur Erzeugung von Quadraturmodulierten Signalen

Procédé et appareil pour la géneration des signaux modulés en quadrature

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.10.2014 Bulletin 2014/40**

(73) Proprietor: **Alcatel Lucent**
**91620 Nozay (FR)**

(72) Inventors:
• **Helou, Didier**
**91620 Nozay (FR)**
• **Dartois, Luc**
**91620 Nozay (FR)**

(74) Representative: **Browne, Robin Forsythe et al**
**Hepworth Browne**
**15 St Paul's Street**
**Leeds LS1 2JG (GB)**

(56) References cited:
**US-A1- 2004 125 888**

• **MICHAEL E GADRINGER ET AL: "Comparison of the imbalance effects in direct conversion transmitters and receivers", IEEE WORKSHOP ON INTEGRATED NONLINEAR MICROWAVE AND MILLIMETRE-WAVE CIRCUITS - INMMIC 2011, 18 April 2011 (2011-04-18), pages 1-4, XP031875704, DOI: 10.1109/INMMIC.2011.5773329 ISBN: 978-1-4577-0650-9**
• **DAVID WISELL ED - DAVID F WAIT: "Identification and Measurement of Transmitter Non-Linearities", IEEE 9TH ARFTG CONFERENCE DIGEST-SPRING, 1 November 2000 (2000-11-01), pages 1-6, XP031056200, ISBN: 978-0-7803-5686-3**

**Description**

**TECHNICAL FIELD**

The present invention relates generally to the field of wireless communications, and, more particularly, to a method and apparatus for generating an amplified radiofrequency (RF) signal.

**BACKGROUND**

In the framework of wireless telecommunication, and in particular digital wireless communication systems, baseband signals carrying information may be modulated onto a RF band prior to broadcasting into free space. Various techniques exist for modulating the baseband signal onto a RF signal with high efficiency and linearity.

Techniques using a single RF modulated signal to feed amplifiers such as class A/B/AB/C linear amplifiers or Doherty power linear amplifiers may convert the complex baseband signal into a modulated RF signal by making use of I/Q quadrature modulators that receive real and imaginary parts of the baseband signal. The signals output by I/Q modulators may then be power amplified. Unfortunately, high power amplifiers may be somewhat nonlinear, and techniques such as Crest Factor Reduction (CFR), Digital Pre-Distorsion (DPD) Linearization and Envelope Tracking (ET) may be further needed to improve power amplified signal.

Some solutions for RF power amplifying stages use analogic circuits with limited power efficiencies (from 16% to 40%). Because of their power consumption, such circuits may require heat sinks with oversized mechanical packages to dissipate generated heat.

US 2004/125888 A1 discloses a quadrature modulation transmitter comprising a digital processing block and an analog processing block.

**SUMMARY OF EXEMPLARY EMBODIMENTS**

Aspects of the present invention are provided in the independent claims. Preferred embodiments are provided in the dependent claims. Some embodiments relate to an apparatus for generating a signal at a carrier frequency, comprising:

   a first digital-to-analog converter, DAC, adapted to receive a sequence of first digital signals at a sub-carrier frequency and to convert said sequence of first digital signals into a corresponding first sequence of first analog voltage values;
   a second DAC, adapted to receive a sequence of second digital signals at said sub-carrier frequency and to convert said sequence of second digital signals into a corresponding second sequence of second analog voltage values;
   an analog electronic combiner;
   a first electronic switch configured to connect an output of the first DAC to a first input of the combiner, and to be operated by a first periodic signal at said carrier frequency so as to sequentially deliver the first analog voltage values of the first sequence to the combiner;
   a second electronic switch configured to connect an output of the second DAC to a second input of the combiner, and to be operated by a second periodic signal at said carrier frequency so as to sequentially deliver the second analog voltage values of said second sequence to the combiner; and
   wherein the analog electronic combiner is configured to combine signals output by the first and second electronic switches to produce a quadrature modulated signal at the carrier frequency.

In some embodiments, the combiner combines signals output by the first and second electronic switches with a relative phase shift of 90° or 270° modulo 360°.

In some embodiments, said first and second periodic signals have a relative phase shift of 90° or 270° modulo 360°, and the analog electronic combiner is configured to add or subtract the signals output by the first and second electronic switches to produce said quadrature modulated signal at the carrier frequency.

The above apparatus may further include:

   a filter being connected to receive the quadrature modulated signal and to substantially remove therefrom component signals at harmonics of said carrier frequency, and/or
   a pair of MOS transistors for first and second electronic switches. In this case, at least one of said MOS power transistors may have a Drain-to-Source On-state resistance in the milli-Ohm range for an operating frequency of about 2 GHz.

In the above apparatus, each of said first and second DACs can be configured to convert sequences of first and second m-bit digital signals with a linearity precision of m bits.

In the above apparatus, each of said first and second DACs may comprise:

n power supply units, PSUs, with n less or equal to m-1; and
a control unit configured to receive said sequence of first or second digital signals, respectively, wherein the digital signals are m-bit digital signals, and the control unit being capable of switching individual ones of the PSUs serially into and out of a voltage delivery line depending on the received sequence of first or second m-bitdigital signals, respectively.

The PSUs may be binary switched PSUs used in voltage-mode, and the control unit can be capable of switching individual ones of the PSUs serially into and out of a voltage delivery line through VMOS switches.

In the above apparatus, each of said first and second DACs may be configured to deliver a first or second analog voltage value, respectively, corresponding to the sum of voltage values delivered by each of the PSUs serially switched into said voltage delivery line. Each of said first and second DACs may further comprise a digital feedback loop to dynamically compensate voltage errors in output signals of the PSUs, wherein the PSUs are binary switched PSUs.

Alternatively, each of said first and second DACs may be configured to deliver a first or second analog voltage value, respectively, the first or second analog voltage values, respectively, corresponding to the sum of voltage values delivered by each of the PSUs serially switched into said voltage delivery line and increased by a voltage margin. Each of said first and second DACs may further comprise:

an analog voltage follower power amplifier configured to receive said first or second analog voltage value, respectively, and to track a reference signal; and
a Digital-to-Analog converter configured to receive said sequence of first or second m-bit digital signals, respectively, and convert said sequence of first or second m-bit digital signals, respectively, into said reference signal.

Some embodiments relate to a method for generating a signal at a carrier frequency, comprising:

at a first digital-to-analog converter, receiving a sequence of first digital signals at a sub carrier frequency and converting said sequence of first digital signals into a fist sequence of first analog voltage values;
at a second digital-to-analog converter, receiving a sequence of second digital signals at said sub carrier frequency and converting said sequence of second digital signals into a second sequence of second analog voltage values;
driving a first electronic switch by a first periodic signal at said carrier frequency to have said first electronic switch delivering sequentially the first analog voltage values of the first sequence;
driving a second electronic switch by a second periodic signal at said carrier frequency to have said second electronic switch delivering sequentially the second analog voltage values of the second sequence; and
producing a quadrature modulated signal at the carrier frequency by combining signals output by the first and second electronic switches.

The above methods may further include:
filtering said quadrature modulated signal to substantially remove harmonics of said carrier frequency.

In the above methods, said first and second periodic signals may have a relative phase shift of 90° or 270° modulo 360°, and combining step comprises adding or subtracting the signals output by the first and second electronic switches to produce said quadrature modulated signal at the carrier frequency.

Additional aspects of embodiments will be set forth, in part, in the detailed description and figures which follow, and in part will be derived from the detailed description. It is to be understood that both the foregoing general description and the following detailed description are only exemplary and do not limit the claimed invention which is defined by the appended claims and limited only by their scope.

Any embodiment and/or aspect (of the invention and/or disclosure) referred to in this description and not fully falling within the scope of said appended claims is to be interpreted as an example useful for understanding the present invention.

## BRIEF DESCRIPTION OF THE DRAWINGS

Some embodiments of apparatus and/or methods are described with reference to the accompanying drawings, in which:

Figure 1 is a schematic diagram illustrating an apparatus for generating an amplified RF signal according to one embodiment;

Figure 2 shows an example of a digital digital-to-analog converter usable in the apparatus of figure 1;
Figure 3 shows another example of a digital digital-to-analog converter usable in the apparatus of figure 1; and
Figure 4 is a flow diagram schematically illustrating an embodiment of a method for generating an amplified RF signal, e.g. with the apparatus of Figure 1.

**DETAILED DESCRIPTION**

The figures and the following description illustrate exemplary embodiments. In the various figures, elements with similar structures and/or functions may be denoted by like reference numerals.

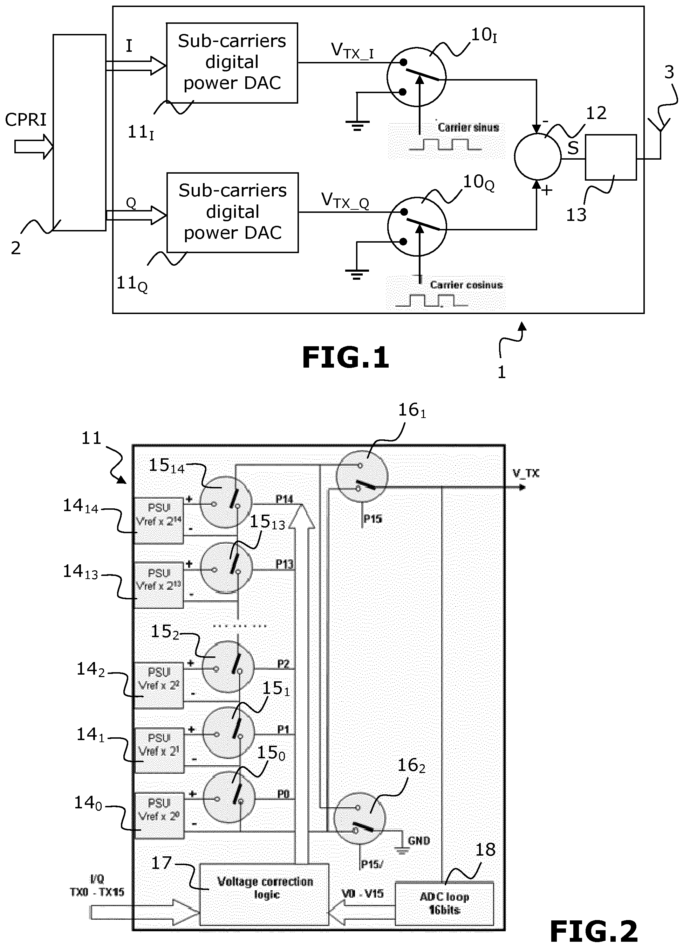

Figure 1 illustrates an apparatus 1 for generating an analog radiofrequency (RF) signal 1, e.g., a RF signal for driving an antenna 3. The apparatus 1 may be used, e.g., in a Remote Radio Head (RRH), where baseband signals received at Long Term Evolution (LTE) sub-carriers, e.g. in a range between 1.4 MHz to 20 MHz, have to be modulated onto a LTE carrier, e.g. in a range between 450 MHz to 2.6 GHz. Below, an illustrative example of apparatus 1 receives, as inputs, sequences of digital signals I and Q on a LTE sub-carrier from a Common Public Radio Interface (CPRI) 2. Each digital signal I and Q is representable by a quantization vector of m bits, for instance of 16 bits. The digital I and Q signals may be produced in the CPRI 2 by a conventional analog-to-digital converter.

Referring to Figure 1, each I and Q m-bit digital signal is sent to the input of a corresponding digital-to-analog converter (DAC) $11_I$, $11_Q$. Each DAC $11_I$, $11_Q$ is adapted to convert a m-bit digital signal into a corresponding analog voltage value $V_{TX\_I}$, $V_{TX\_Q}$ at a power corresponding to a desired power amplification. Hence, first DAC $11_I$ delivers sequences of first analog voltage values $V_{TX\_I}$ and in parallel, DAC $11_Q$ delivers sequences of second analog voltage values $V_{TX\_Q}$. A description of examples of the DACs $11_I$, $11_Q$ will be given in figure 2.

Downstream, the apparatus 1 includes two power-controlled electronic switches $10_I$, $10_Q$. The first electronic switch $10_I$ is configured to be driven by a first periodic signal, e.g., a first square-wave signal, at a carrier frequency (e.g., a LTE carrier frequency) while the second electronic switch $10_Q$ is configured to be driven by a second periodic signal, e.g., a second square-wave signal, at the carrier frequency. The first and second periodic signals have a relative phase shift of about 90°, e.g., 90°± 20%, 90°± 10%, 90°± 5% or 90°± 1%, or of about 270° modulo 360°, e.g., 270°± 20%, 270°± 10%, 270°± 5% or 270°± 1%. For example, each modulator $10_I$, $10_Q$ may comprise a pair of VMOS power transistors (not shown), which acts as a MOS switch with low Drain-to-Source On-state resistance, also known as $R_{DS(ON)}$ (typically in the milli-Ohm range at the carrier frequency). First electronic switch $10_I$ is connected to the output of first DAC $11_I$ so as to sequentially deliver, when switched on, the sequence of first analog values $V_{TX\_I}$. In a similar way, second electronic switch $10_Q$ is connected to the output of second DAC $11_Q$ so as to sequentially deliver, when switched on, the sequence of second analog values $V_{TX\_Q}$.

An analog electronic combiner 12, i.e. an adder or subtractor, is connected to combine the resulting signals output by the first and second electronic switches $10_I$, $10_Q$ to produce an output signal $S(\omega_{LTE}t)$ corresponding to an amplified RF signal at the carrier frequency:

$$S\left(\omega_{LTE}t\right) = V_{TX\_Q}\cos\left(\omega_{LTE}t\right) \pm V_{TX\_I}\sin\left(\omega_{LTE}t\right) + \text{higher harmonics of } \omega_{LTE}.$$

Here, $\omega_{LTE}$ is the LTE angular frequency. In the above equation, the plus sign is used when the combiner 12 is an adder, and the minus sign is used when the combiner 12 is a subtractor.

For example, analog electronic combiner 12 may comprise a transformer whose primary coil has a first terminal connected to the output of first electronic switch $10_I$ and a second terminal connected to the output of second electronic switch $10_Q$.

In other embodiments, first and second periodic signals are in-phase, and combiner is adapted to combine the signals output by the first and second electronic switch to produce the quadrature modulated signal at the carrier frequency.

Typically, the first and second periodic signal controlling will comprise higher harmonics (e.g., $3\omega_{LTE}$, $5\omega_{LTE}$, $7\omega_{LTE}$...), e.g., if the first and second periodic signals are square waves, and such higher harmonics in the frequency $\omega_{LTE}$ are preferably removed. Hence, apparatus 1 may also comprise an electronic filter 13 connected to receive the output of combiner 12 to perform such filtering out of higher harmonics and to deliver such a filtered power amplified RF signal to a transmitting antenna 3. Hence, contrary to classical solutions in which I and Q digital baseband signals are modulated onto the carrier signal through I/Q quadrature modulators, and then power-amplified, apparatus 1 achieves the power amplification at the baseband signal level, and the modulation onto the carrier frequency through the electronic switches and the combiner.

As indicated above, the DACs $11_I$, $11_Q$ typically convert digital received signals, which are represented by m quantization bits, into analog voltage values $V_{TX\_I}$, $V_{TX\_Q}$, which are approximately closest to the received digital values.

Hence, if the received digital signals are 16-bit digital signals, the digital-to-analog conversion may be performed with a linearity precision of about 16 bits. This can be made e.g., by performing truncation or rounding of the received values. Alternatively and as detailed below, some embodiments for DAC enable to perform the digital-to-analog conversion with high linearity precision.

Figure 2 illustrates one possible embodiment for an example 16-bit DAC 11 that converts a received 16-bit digital signal into an analog voltage value V_TX with a linearity precision of 16 bits. The DAC 11 may be used to construct the DAC $11_I$, $11_Q$ of figure 1.

As shown in figure 2, the example DAC 11 comprises fifteen binary-switched power supply units (PSUs) $14_0$, $14_1$...$14_{14}$ used in voltage-mode for delivering analog voltage values up to a desired maximum power, e.g. 60 Watts. The PSUs $14_0$, $14_1$...$14_{14}$ have output voltage values increasing from an initial reference value $V_{ref}$ for PSU $14_0$ to a maximum value of $V_{ref} \times 2^{14}$ for PSU $14_{14}$. From the PSU $14_k$ to the PSU $14_{k+1}$, the output power is increased by a step in power of 2.

More precisely, assuming $V_{ref}$ is equal to 32 Volts/$2^{14}$, PSU $14_0$ will deliver 1 mVolts, PSU $14_1$ will deliver 2 mVolts... and PSU $14_{14}$ will deliver 32 Volts.

The example DAC 11 comprises serial line of fifteen serial connected switches $15_0$, $15_1$...$15_{14}$, wherein each switch is controlled by a corresponding weight P0, P1... P14. Each switch is adapted to be switched on, depending on the control value "1" or "0" of the corresponding weight, either in a first position that provides a connection of a corresponding PSU $14_0$, $14_1$...$14_{14}$ into the serial line, or in a second position for which the corresponding PSU $14_0$, $14_1$...$14_{14}$ is not connected into said serial line. Thus, the serial line provides a matrix enabling to connect all or part of the PSUs into the serial line, depending on the digital signal received at the input of DAC 11, and the weight value delivered by a control unit 17. For instance, if the digital signal I or Q received at the input of DAC 11 corresponds to 32 Volts, only weight $P_{14}$ will have corresponding switch $15_{14}$ closed in its first position, while all the other weights will switch the other switches to their second positions. Two additional switches $16_1$ and $16_2$ controlled by a common signal P15 can be simultaneously switched on to close the circuit comprising all or part of PSUs $14_0$, $14_1$...$14_{14}$, depending on the state of corresponding switches $15_0$, $15_1$...$15_{14}$, between the output of DAC 11 and the electrical ground. When these additional switches are closed, the value V_TX which is delivered at the output corresponds to the sum of the voltages delivered by each PSU $14_i$ for which the corresponding switch $15_i$ is in its first position.

All switches $15_0$ to $15_{14}$, $16_1$ and $16_2$ may be, e.g., power VMOS switches with low $R_{DS(ON)}$ (typically in the milli-Ohm range for an operating frequency of about 20 MHz). Such power VMOS switches adapted to work at subcarrier frequency (e.g., maximum of 20 MHz for LTE) can be found on the market at quite low cost.

Still referring to Figure 2, the voltage errors of the fifteen binary switched PSU $14_0$, $14_1$...$14_{14}$, and voltage drops in the power VMOS $15_0$ to $15_{14}$, $16_1$ and $16_2$ may be dynamically compensated by a digital feedback loop comprising an analog-to-digital-converter 18 adapted to convert the output voltage value V_TX into a digital signal comprising 16 bits $V_0$, $V_1$...$V_{16}$. These bits are provided to control unit 17 which can compensate, when needed, the voltage error, in particular by changing some of the least significant weights. The compensated values may be advantageously stored into a calibration table in control unit 17, in order to speed-up the process of correcting non linearities in the DAC.

Other embodiments for DAC 11 can be easily derived from embodiment of figure 2: for instance, it is possible to use a reduced number of binary-switched PSU $14_i$, to reduce the range of voltages which can be generated (e.g. from 1 V to 32 V), and to use one or several voltage dividers to derive the other voltages (e.g. from 1 mV to 1 V).

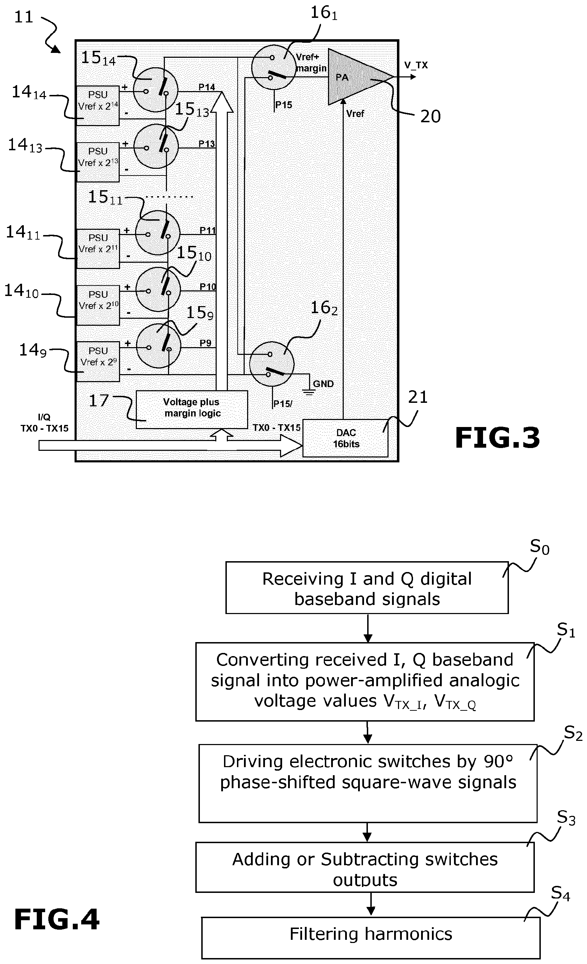

Another exemplary embodiment for digital DAC 11 is illustrated in figure 3. This embodiment of the DAC 11 comprises a first stage which provides a digital binary power supply with values from $V_{ref} \times 2^9$ to $V_{ref} \times 2^{14}$ (for example from 1 V, 2V, 4V to 32 V), plus a voltage margin which can be set around 1 V. The first stage comprises six binary switched PSU $14_9$ to $14_{14}$ which can deliver analogic voltage values between a lowest value $V_{ref} \times 2^9$ and a maximum value of $V_{ref} \times 2^{14}$, in steps of powers of 2, according to the values of the weights P9 to P14 applied at the entries of the respective switches $15_9$ to $15_{14}$. A control unit 17 delivers weight P9 to P14 and the voltage margin. Contrary to DAC 11 shown in figure 2, when additional switches $16_1$ and $16_2$ are closed, the value delivered by the first stage corresponds to the sum of the voltages provided by each PSU $14_i$ for which corresponding switch $15_i$ is in its first position, increased by the voltage margin. In a second stage, an analog voltage follower power amplifier 20 powered by the first digital stage tracks a reference voltage output by a Digital-to-Analog converter 21 which receives and converts directly the digital signal I or Q. Hence, power amplifier 20 delivers a corrected analogic voltage value $V_{TX}$.

This architecture may be operated without dynamical compensation of the errors of power MOS switches $15_9$ to $15_{14}$. The power loss is limited to the voltage margin. If this voltage margin is equal to 1 V, this may lead to an additional power loss of the analog second stage which is less than 1 Watt (for a maximum current value of 1 A).

Based on the present description, a person of ordinary skill in the relevant arts would easily understand how the DAC 11 as shown in figures 2 and 3 can be generalized to other ranges of voltage values and other values of m.

Some of the above-described may offer advantages.

By use of power-controlled electronic switches driven at the carrier frequency, various embodiments may provide a digital architecture for the RF amplifier. Indeed, VMOS transistors in the digital DACs and in the electronic switches are used as switching devices, which may have high power efficiency, e.g., a power efficiency of 80-90%.

In addition, various embodiments of the apparatus for generating an amplified RF signal may have a more compact design due to reduced heat dissipation. Indeed, VMOS power transistors typically generate heat at the switching time, but low Drain-to-Source On-state resistance, $R_{DS(ON)}$, of such transistors at the operating frequency (e.g., up to 20 MHz for transistors used in DACs, and up to 2 GHz for transistors used in electronic switches), may lead to small power consumptions.

In various embodiments, the RF power amplifiers may be operated without RF signal conditioning, and calibration and predistorsion may be done directly on digital I and Q envelope signals controlling the two DACs.

In embodiments using low power, the power may be supplied by small batteries, solar panels, or wind generators. Such power sources may be particularly useful for deployments of Remote Radio Heads to extend the coverage of wireless communication systems.

In addition, power transistors operating at carrier frequency may be simpler and less costly than power transistors used for other next class S generation power amplifiers.

Various embodiments of the power amplifiers may be used for different applications, e.g., in LTE device, or for high power amplification with moderate signal bandwidth but where center frequency can vary, like in devices for digital TV broadcast.

Some embodiments also provide a method for generating an amplified RF signal. Figure 4 is a flow diagram illustrating such a method.

The method includes receiving In-Phase and Quadrature digital signals I and Q at a sub carrier frequency (step $S_0$), for instance from a Common Public Radio Interface. Each value of the digital signals I and Q is represented by a vector of m quantization bits.

In step $S_1$, digital signal I (respectively Q) is converted into an analog voltage value $V_{TX\_I}$ (respectively $V_{TX\_Q}$). The linear conversion may be performed with a linearity precision as close as possible to the quantized values.

In step $S_2$, a first electronic switch configured to deliver the resulting voltage values $V_{TX\_I}$ when switched on is driven by a first periodic signal at said carrier frequency while a second electronic switch configured to deliver the resulting voltage values $V_{TX\_Q}$ when switched on is driven by a second periodic signal at said carrier frequency. The first and second periodic signals, e.g., square-wave signals, have a relative phase shift of about 90°, e.g., 90° $\pm$ 20%, 90° $\pm$ 10%, 90° $\pm$ 5% or 90° $\pm$ 1%.

Signals resulting from step $S_2$ are then combined, more specifically added or subtracted (step $S_3$), and then may be filtered (step $S_4$) to remove higher harmonics and deliver an amplified RF signal at the carrier frequency which may be transmitted by a RF antenna.

As previously indicated, first and second periodic signals may also be in-phase. In this case, combining step $S_3$ comprises combining the signals output by the first and second electronic switch with a relative phase of 90° or 270°, to produce the quadrature modulated signal at the carrier frequency

Although some embodiments of the present invention have been illustrated in the accompanying Drawings and described in the foregoing Detailed Description, it should be understood that the present invention is not limited to the disclosed embodiments. The scope of the present invention is defined by the scope of the following claims.

**Claims**

1. An apparatus for generating a signal at a carrier frequency, comprising:

   a first digital-to-analog converter, DAC, ($11_I$) adapted to receive a sequence of first digital signals at a sub-carrier frequency and to convert said sequence of first digital signals into a corresponding first sequence of first analog voltage values;
   a second DAC, ($11_Q$) adapted to receive a sequence of second digital signals at said sub-carrier frequency and to convert said sequence of second digital signals into a corresponding second sequence of second analog voltage values;
   an analog electronic combiner (12);
   said apparatus being **characterized by**:

   a first electronic switch ($10_I$) configured to connect an output of the first DAC ($11_I$) to a first input of the combiner (12), and to be operated by a first periodic signal at said carrier frequency so as to sequentially deliver the first analog voltage values of said first sequence to the combiner;
   a second electronic switch ($10_Q$) configured to connect an output of the second DAC ($11_Q$) to a second input of the combiner (12), and to be operated by a second periodic signal at said carrier frequency so as to sequentially deliver the second analog voltage values of said second sequence to the combiner; and

wherein the analog electronic combiner (12) is configured to combine signals output by the first and second electronic switches ($10_I$, $10_Q$) to produce a quadrature modulated signal at the carrier frequency.

2. The apparatus according to claim 1, wherein said combiner (12) combines said signals output by the first and second electronic switches with a relative phase shift of 90° or 270° modulo 360°.

3. The apparatus of claim 1, wherein the first and second periodic signals have a relative phase shift of 90° or 270° modulo 360°, and wherein the analog electronic combiner (12) is configured to add or subtract the signals output by the first and second electronic switches ($10_I$, $10_Q$) to produce said quadrature modulated signal at the carrier frequency.

4. The apparatus according to claim 1, 2, or 3, further comprising a filter (13) being connected to receive the quadrature modulated signal and to remove therefrom component signals at harmonics of said carrier frequency.

5. The apparatus according to anyone of claims 1 to 4, wherein each of said first and second electronic switches ($10_I$, $10_Q$) comprises a pair of MOS transistors.

6. The apparatus according to anyone of claims 1 to 5, wherein each of said first and second DACs ($11_I$, $11_Q$) comprises:

   n power supply units, PSUs, ($14_0$, $14_1...14_{14}$) with n less or equal to m-1; and
   a control unit (17) configured to receive said sequence of first or second digital signals, respectively, wherein the digital signals are m-bit digital signals, and the control unit (17) being capable of switching individual ones of the PSUs serially into and out of a voltage delivery line depending on the received sequence of first or second m bit-digital signals, respectively.

7. The apparatus according to claim 6, wherein said n PSUs ($14_0$, $14_1...14_{14}$) are binary switched PSUs used in voltage-mode.

8. The apparatus according to claim 6, wherein said control unit (17) is capable of switching individual ones of the PSUs serially into and out of the voltage delivery line through MOS switches ($15_0$, $15_1...151_4$).

9. The apparatus according to anyone of claim 6, wherein each of said first and second DACs ($11_I$, $11_Q$) is configured to deliver a first or second analog voltage value, respectively, corresponding to the sum of voltage values delivered by each of the PSUs serially switched into said voltage delivery line.

10. The apparatus according to claim 9, wherein each of said first and second DACs ($11_I$, $11_Q$) further comprises a digital feedback loop to dynamically compensate voltage errors in output signals of the PSUs, wherein the PSUs are binary switched PSUs.

11. The apparatus according to claim 6, wherein each of said first and second DACs ($11_I$, $11_Q$) is configured to deliver a first or second analog voltage value, respectively, the first and second analog voltage values, respectively, corresponding to the sum of voltage values delivered by each of the PSUs serially switched into said voltage delivery line and increased by a voltage margin.

12. The apparatus according to claim 11, wherein each of said first and second DACs ($11_I$, $11_Q$) further comprises:

   an analog voltage follower power amplifier (20) configured to receive said first or second analog voltage value, respectively, and to track a reference signal; and
   a Digital-to-Analog converter (21) configured to receive said sequence of first or second m bit-digital signals, respectively, and convert said sequence of first or second m bit-digital signals, respectively, into said reference signal.

13. A method for generating a signal at a carrier frequency, comprising:

   at a first digital-to-analog converter, receiving ($S_0$) a sequence of first digital signals at a sub carrier frequency and converting ($S_1$) said sequence of first digital signals into a first sequence of first analog voltage values;
   at a second digital-to-analog converter,' receiving ($S_0$) a sequence of second digital signals at said sub carrier frequency and converting ($S_1$) said sequence of second digital signals into a second sequence of second analog

voltage values;

driving ($S_2$) a first electronic switch by a first periodic signal at said carrier frequency to have said first electronic switch delivering sequentially the first analog voltage values of said first sequence;

driving ($S_2$) a second electronic switch by a second periodic signal at said carrier frequency to have said second electronic switch delivering sequentially the second analog voltage values of said second sequence; and

producing a quadrature modulated signal at the carrier frequency by combining ($S_3$) signals output by the first and second electronic switches.

14. The method according to claim 13, wherein said first and second periodic signals have a relative phase shift of 90° or 270° modulo 360°, and wherein combining step ($S_3$) comprises adding or subtracting the signals output by the first and second electronic switches ($10_I$, $10_Q$) to produce said quadrature modulated signal at the carrier frequency.

15. The method according to claim 13 or 14, further comprising filtering ($S_4$) said quadrature modulated signal to remove harmonics of said carrier frequency.

**Patentansprüche**

1. Vorrichtung zum Erzeugen eines Signals bei einer Trägerfrequenz, die das Folgende aufweist:

   - einen ersten Digital-Analog-Wandler, DAC, ($11_I$), der dazu ausgelegt ist, eine Sequenz aus ersten digitalen Signalen bei einer Subträgerfrequenz zu empfangen und die Sequenz aus den ersten digitalen Signalen in eine entsprechende erste Sequenz aus ersten analogen Spannungswerten umzuwandeln;
   - einen zweiten DAC, ($11_Q$), der dazu ausgelegt ist, eine Sequenz aus zweiten digitalen Signalen bei der Subträgerfrequenz zu empfangen und die Sequenz aus zweiten digitalen Signalen in eine entsprechende zweite Sequenz aus zweiten analogen Spannungswerten umzuwandeln;
   - einen analogen elektronischen Kombinierer (12);

   wobei die Vorrichtung durch das Folgende gekennzeichnet ist:

   - einen ersten elektronischen Schalter ($10_I$), der dazu konfiguriert ist, einen Ausgang des ersten DAC ($11_I$) bei einem ersten Eingang des Kombinierers (12) zu verbinden und durch ein erstes periodisches Signal bei der Trägerfrequenz gesteuert zu werden, so dass die ersten analogen Spannungswerte der ersten Sequenz sequentiell an den Kombinierer übermittelt werden;
   - einen zweiten elektronischen Schalter ($10_Q$), der dazu konfiguriert ist, einen Ausgang des zweiten DAC ($11_Q$) mit einem zweiten Eingang des Kombinierers (12) zu verbinden und durch ein zweites periodisches Signal bei der Trägerfrequenz gesteuert zu werden, so dass die zweiten analogen Spannungswerte der zweiten Sequenz sequentiell an den Kombinierer übermittelt werden; und

   wobei der analoge elektronische Kombinierer (12) dazu konfiguriert ist, die Signale, die von den ersten und zweiten elektronischen Schaltern ($10_I$, $10_Q$) ausgegeben werden, zu kombinieren, um ein quadraturmoduliertes Signal bei der Trägerfrequenz zu erzeugen.

2. Vorrichtung nach Anspruch 1,
   wobei der Kombinierer (12) die von dem ersten und zweiten elektronischen Schaltern ausgegebenen Signale mit einer relativen Phasenverschiebung von 90° oder 270° modulo 360° kombiniert.

3. Vorrichtung nach Anspruch 1,
   wobei die ersten und zweiten periodischen Signale eine relative Phasenverschiebung von 90° oder 270° modulo 360° aufweisen, und wobei der analoge elektronische Kombinierer (12) dazu konfiguriert ist, die von den ersten und zweiten elektronischen Schaltern ($10_I$, $10_Q$) ausgegebenen Signale zu addieren oder zu subtrahieren, um das quadraturmodulierte Signal mit der Trägerfrequenz zu erzeugen.

4. Vorrichtung nach Anspruch 1, 2 oder 3,
   die ferner ein Filter (13) aufweist, das verbunden ist, um das quadraturmodulierte Signal zu empfangen und Komponentensignale bei Oberwellen der Trägerfrequenz davon zu entfernen.

5. Vorrichtung nach einem der Ansprüche 1 bis 4,

wobei jeder der ersten und zweiten elektronischen Schalter ($10_I$, $10_Q$) ein Paar MOS-Transistoren aufweist.

6. Vorrichtung nach einem der Ansprüche 1 bis 5,
wobei jeder der ersten und zweiten DAC ($11_I$, $11_Q$) das Folgende aufweist:

   - n Stromversorgungseinheiten, PSU, ($14_0$, $14_1...14_{14}$) mit n kleiner oder gleich m-1; und
   - eine Steuereinheit (17), die derart konfiguriert ist, die Sequenz aus ersten bzw. zweiten digitalen Signalen zu empfangen,
   wobei die digitalen Signale m-Bit-Digitalsignale sind, und die Steuereinheit (17) in der Lage ist, einzelne der PSU seriell mit einer Spannungsbereitstellungsleitung schaltbar zu verbinden und zu trennen, abhängig von der empfangenen Sequenz aus ersten oder zweiten m-Bit-Digitalsignalen.

7. Vorrichtung nach Anspruch 6,
wobei die n PSU ($14_0$, $14_1...14_{14}$) binär geschaltete PSU sind, die im Spannungsmodus verwendet werden.

8. Vorrichtung nach Anspruch 6,
wobei die Steuereinheit (17) in der Lage ist, einzelne der PSU über MOS-Schalter ($15_0$, $15_1...15_{14}$) seriell mit einer Spannungsbereitstellungsleitung schaltbar zu verbinden und zu trennen

9. Vorrichtung nach einem beliebigen der Ansprüche 6,
wobei jeder der ersten und zweiten DAC ($11_I$, $11_Q$) dazu konfiguriert ist, einen ersten bzw. zweiten analogen Spannungswert bereitzustellen, die der Summe der Spannungswerte entspricht, die von jedem der PSU bereitgestellt werden, die seriell in die Spannungsbereitstellungsleitung hinzugeschaltet sind.

10. Vorrichtung nach Anspruch 9,
wobei jeder der ersten und zweiten DAC (11I, 11Q) ferner eine digitale Rückkopplungsschleife aufweist, um Spannungsfehler in Ausgangssignalen der PSU dynamisch zu kompensieren,
wobei die PSU binär geschaltete PSU sind.

11. Vorrichtung nach Anspruch 6,
wobei jeder der ersten und zweiten DAC (111, 11Q) dazu konfiguriert ist, einen ersten oder zweiten analogen Spannungswert bereitzustellen, wobei der erste und zweite analoge Spannungswert der Summe der Spannungswerte entspricht, die von jedem der PSU bereitgestellt werden, die seriell in die Spannungsbereitstellungsleitung hinzugeschaltet sind und um einen Spannungsmarge erhöht werden.

12. Vorrichtung nach Anspruch 11,
wobei jeder der ersten und zweiten DAC (111, 11Q) ferner das Folgende aufweist:

   - einen analogen Spannungsfolger-Leistungsverstärker (20), der dazu konfiguriert ist, den ersten bzw. zweiten analogen Spannungswert zu empfangen und ein Referenzsignal zu folgen; und
   - einen Digital-Analog-Wandler (21), der dazu konfiguriert ist, die Sequenz der ersten bzw. zweiten m-Bit-Digitalsignale zu empfangen und die Sequenz der ersten bzw. zweiten m-Bit-Digitalsignale in das Referenzsignal umzuwandeln.

13. Verfahren zum Erzeugen eines Signals bei einer Trägerfrequenz, das das Folgende umfasst:

   - an einem ersten Digital-Analog-Wandler, Empfangen ($S_0$) einer Sequenz aus ersten digitalen Signalen bei einer Subträgerfrequenz und Umwandeln ($S_1$) der Sequenz aus ersten digitalen Signalen in eine erste Sequenz aus ersten analogen Spannungswerten;
   - an einem zweiten Digital-Analog-Wandler, Empfangen ($S_0$) einer Sequenz aus zweiten digitalen Signalen bei der Subträgerfrequenz und Umwandeln ($S_1$) der Sequenz aus zweiten digitalen Signalen in eine zweite Sequenz aus zweiten analogen Spannungswerten;
   - Ansteuern ($S_2$) eines ersten elektronischen Schalters durch ein erstes periodisches Signal mit der Trägerfrequenz, um zu bewirken, dass der erste elektronische Schalter die ersten analogen Spannungswerte der ersten Sequenz sequentiell bereitstellt;
   - Ansteuern ($S_2$) eines zweiten elektronischen Schalters durch ein zweites periodisches Signal mit der Trägerfrequenz, um zu bewirken, dass der zweite elektronische Schalter sequentiell die zweiten analogen Spannungswerte der zweiten Sequenz bereitstellt; und

- Erzeugen eines quadraturmodulierten Signals bei der Trägerfrequenz durch Kombinieren (S₃) von Signalen, die von dem ersten und zweiten elektronischen Schalter ausgegeben werden.

14. Verfahren nach Anspruch 13, wobei die ersten und zweiten periodischen Signale eine relative Phasenverschiebung von 90° oder 270° modulo 360° aufweisen, und wobei der Kombinierschritt (S3) das Addieren oder Subtrahieren der von den ersten und zweiten elektronischen Schaltern (101, 10Q) ausgegebenen Signale umfasst, um das quadraturmodulierte Signal bei der Trägerfrequenz zu erzeugen.

15. Verfahren nach Anspruch 13 oder 14, ferner umfassend Filtern (S4) des quadraturmodulierten Signaln, um Oberwellen der Trägerfrequenz zu entfernen.

**Revendications**

1. Équipement pour la génération d'un signal à une fréquence porteuse, comprenant :

   un premier convertisseur numérique-analogique (DAC), (11I) adapté pour recevoir une séquence de premiers signaux numériques à une fréquence sous-porteuse et pour convertir ladite séquence de premiers signaux numériques en une première séquence de premières valeurs analogiques de tension ;
   un deuxième DAC, (11Q) adapté pour recevoir une séquence de deuxièmes signaux numériques à ladite fréquence de sous-porteuse et pour convertir ladite séquence de deuxièmes signaux numériques en une deuxième séquence correspondante de deuxièmes valeurs analogiques de tension ;
   un combinateur électronique analogique (12) ;
   ledit équipement étant **caractérisé en ce que** :

   un premier commutateur électronique (10I) est configuré pour connecter une sortie du premier DAC (11I) à une première entrée du combinateur (12), et pour fonctionner par le biais d'un premier signal périodique à ladite fréquence porteuse de manière à fournir en séquence les premières valeurs analogique de tension de ladite première séquence au combinateur ;
   un deuxième commutateur électronique (10Q) est configuré pour connecter une sortie du deuxième DAC (11Q) à une deuxième entrée du combinateur (12), et pour fonctionner par le biais d'un deuxième signal périodique à ladite fréquence porteuse de manière à fournir en séquence les deuxièmes valeurs analogiques de tension de ladite deuxième séquence au combinateur ; et
   selon lequel le combinateur électronique analogique (12) est configuré pour combiner des signaux sortant des premier et deuxième commutateurs (10I, 10Q) afin de produire un signal modulé en quadrature à la fréquence porteuse.

2. Équipement selon la revendication 1, selon lequel le combinateur (12) combine lesdits signaux sortant des premier et deuxième commutateurs électroniques avec un décalage de phase relatif de 90° ou de 270° modulo 360°.

3. Équipement selon la revendication 1, selon lequel les premier et deuxième signaux périodiques présentent un décalage de phase relatif de 90° ou de 270° modulo 360°, et selon lequel le combinateur électronique analogique (12) est configuré pour ajouter ou soustraire les signaux sortants des premier et deuxième commutateurs électroniques (10I, 10Q) afin de produire ledit signal modulé en quadrature à la fréquence porteuse.

4. Équipement selon la revendication 1, 2, ou 3, comprenant en outre un filtre (13) connecté pour recevoir le signal modulé en quadrature et pour enlever de ce dernier des signaux le composant à des fréquences harmoniques de ladite fréquence porteuse.

5. Équipement selon l'une quelconque des revendications 1 à 4, selon lequel chacun des dits premier et deuxième commutateurs électroniques (10I, 10Q) comprend une paire de transistors MOS.

6. Équipement selon l'une quelconque des revendications 1 à 5, selon lequel chacun des dits premier et deuxième DAC (11I, 11Q) comprend :

   n unités d'alimentation (PSU), (140, 141...1414) dans lequel n est égal ou inférieur à m-1 ; et
   une unité de commande (17) configurée pour recevoir ladite séquence de premiers ou deuxièmes signaux numériques, respectivement, selon lequel les signaux numériques sont des signaux numériques m-bit, et l'unité de commande (17) est capable de commuter des unités individuelles d'alimentation parmi les PSU en série, dans et en dehors, d'une ligne de fourniture de tension en fonction de la séquence reçue de premiers ou deuxièmes signaux numériques m-bit, respectivement.

7. Équipement selon la revendication 6, selon lequel lesdites n PSU (140, 141...1414) sont des PSU à commutation binaire utilisées en mode à tension.

8. Équipement selon la revendication 6, selon lequel ladite unité de commande (17) est capable de commuter des unités individuelles d'alimentation parmi les PSU en série, dans et en dehors, de la ligne de fourniture de tension via des commutateurs MOS (150, 151...1514).

9. Équipement selon la revendication 6, selon lequel chacun des dits premier et deuxième DAC (11I, 11Q) est configuré pour fournir une première ou une deuxième valeur analogique de tension, respectivement, correspondant à la somme des valeurs de tension fournies par chacune des PSU commutées en série dans ladite ligne de fourniture de tension.

10. Équipement selon la revendication 9, selon lequel chacun des dits premier et deuxième DAC (11I, 11Q) comprend en outre une boucle de retour numérique afin de compenser de manière dynamique des erreurs de tension dans les signaux de sortie des PSU, selon lequel les PSU sont des PSU à commutation binaire.

11. Équipement selon la revendication 6, selon lequel chacun des dits premier et deuxième DAC (11I, 11Q) est configuré pour fournir une première ou une deuxième valeur analogique de tension, respectivement, les première et deuxième valeurs analogiques de tension correspondantes, respectivement, à la somme des valeurs de tension fournies par chacune des PSU commutée en série dans ladite ligne de fourniture de tension et augmentées d'une marge de tension.

12. Équipement selon la revendication 11, selon lequel chacun des dits premier et deuxième DAC (11I, 11Q) comprend en outre :

   un amplificateur de puissance suiveur de tension analogique (20) configuré pour recevoir ladite première ou deuxième valeur analogique de tension, respectivement, et pour suivre un signal de référence ; et
   un convertisseur numérique-analogique (21) configuré pour recevoir ladite séquence de premiers ou deuxièmes signaux numériques m-bit, respectivement, et pour convertir ladite séquence de premiers ou deuxièmes signaux numériques m-bit, respectivement, en ledit signal de référence.

13. Procédé de génération d'un signal à une fréquence porteuse, comprenant :

   au niveau d'un premier convertisseur numérique-analogique, la réception (S0) d'une séquence de premiers signaux numériques à une fréquence sous-porteuse et la conversion (S1) de ladite séquence de premiers signaux numériques en une première séquence de premières valeurs analogiques de tension ;
   au niveau d'un deuxième convertisseur numérique-analogique, la réception (S0) d'une séquence de deuxièmes signaux numériques à ladite fréquence de sous-porteuse et la conversion (S1) de ladite séquence de deuxièmes signaux numériques en une deuxième séquence correspondante de deuxièmes valeurs analogiques de tension ;
   la commande (S2) d'un premier commutateur électronique par le biais d'un signal périodique à ladite fréquence porteuse pour fournir en séquence, par le biais dudit premier commutateur électronique, les premières valeurs analogiques de tension de ladite première séquence ;
   la commande (S2) d'un deuxième commutateur électronique par le biais d'un deuxième signal périodique à ladite fréquence porteuse pour fournir en séquence, par le biais dudit deuxième commutateur électronique, les deuxièmes valeurs analogiques de tension de ladite deuxième séquence ; et
   la production d'un signal modulé en quadrature à la fréquence porteuse en combinant (S3) des signaux sortant des premier et deuxième commutateurs électroniques.

14. Procédé selon la revendication 13, selon lequel les premier et deuxième signaux périodiques présentent un décalage de phase relatif de 90° ou de 270° modulo 360°, et selon lequel l'étape de combinaison (S3) comprend l'ajout ou la soustraction des signaux sortant des dits premier et deuxième commutateurs électroniques (10I, 10Q) afin de produire ledit signal modulé en quadrature à la fréquence porteuse.

**15.** Procédé selon la revendication 13 ou la revendication 14, comprenant en outre le filtrage (S4) dudit signal modulé en quadrature afin d'enlever des fréquences harmoniques de ladite fréquence porteuse.

**FIG.1**

**FIG.2**

**FIG.3**

**FIG.4**

**EP 2 785 000 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004125888 A1